# EUROPEAN PATENT APPLICATION

(11) **EP 3 070 754 A1**
(43) Date of publication of application: **21.09.2016**
(21) Application number: 15461515.7
(22) Date of filing: 17.03.2015
(51) Int. Cl.: H01L 43/06

(54) **A Hall effect element**

(71) Applicant: Instytut Technologii Materialów Elektronicznych, 01-919 Warszawa (PL)
(72) Inventor: Ciuk, Tymoteusz, 03-159 Warszawa (PL); Strupinski, Wlodzimierz, 01-934 Warszawa (PL)
(74) Representative: Sielewiesiuk, Jakub

(57) **Abstract**

The invention is related to a Hall effect element comprising:
a layer of graphene deposited on a layer of silicon carbide; wherein said layer of graphene having a pattern of terraces and step edges arranged in parallel to one another on the surface of said layer of graphene;
at least four metallic elements situated on said layer of graphene and forming ohmic contact with said layer of graphene, wherein
two of said metallic elements placed at a certain distance opposite to each other are inputs (IN1, IN2) suitable for feeding the Hall effect element with direct current
two other of said metallic elements placed at a certain distance opposite to each other are outputs (OUT1, OUT2)
characterised in that a straight line connecting said inputs (IN1, IN2) forms an angle α equal to 0° or 90° with said terraces and step edges.

## Description

A Hall effect element made of graphene on SiC with minimalized Off-set voltage.

Graphene has been suggested an active layer in Hall effect elements due to its two-dimensional form, low carrier concentration and high carrier mobility. Since in graphene the top of the valence band and the bottom of the conduction band touch each other in the K and K' points of the first Brillouin zone (so called Dirac points), graphene has no bandgap. It is considered either a semimetal or a gapless semiconductor. For these reasons a graphene-based Hall effect element is believed to operate at higher temperatures than traditional Hall effect elements in which the active layer is made of a semiconducting material e.g. gallium arsenide or indium antimonide.

### Patent CN102185099 (A)

The invention discloses a Hall element and a manufacturing method thereof. An active area of the Hall element is made of a graphene material; a pair of exciting electrodes is in contact with two ends of a graphene channel so as to provide an electric current source or a voltage source; and a pair of Hall electrodes is in contact with both sides of the graphene channel so as to test Hall voltage. The Hall element has the advantages of high sensitivity, very high linearity and temperature stability, capability of working well in a voltage mode and an electric current mode, simple preparation process and suitability for preparing a Hall integrated circuit.

### US2014346579 (A1)

A magnetic field element device having a semiconductor body, whereby the semiconductor body has a top side and a bottom side, and whereby the semiconductor body has a substrate layer and a passivation layer formed above the substrate on the top side of the semiconductor body, and one or more integrated electronic components are formed in the substrate layer of the semiconductor body, and a Hall plate is provided on the top side of the semiconductor body above the passivation layer, and the Hall plate is formed of a graphene compound.

Among many technologies of graphene synthesis, two are preferable for mass production of graphene-based Hall effect elements. These are the deposition of graphene by vapor phase epitaxy on a substrate comprising a surface of silicon carbide (EP 2392547 (A2)) and the heating of a carbide crystal for a sufficient time so that at least one non-carbon element evaporates from the crystal face of the carbide crystal to form a graphitic layer (US 2009226638 (A1)). Most commonly hexagonal polytypes (4H and 6H) of silicon carbide are chosen a target substrate.

In both mentioned technologies, the growth-preceding *in-situ* etching of silicon carbide surface promotes the phenomenon of step bunching in which the atomic steps of silicon carbide cluster to form macro steps, typically dozens of times higher than the atomic steps. The resulting is a surface of silicon carbide marked with a pattern of terraces and step edges. The presence of the atomic steps in silicon carbide is unavoidable. It has its origin in the technical challenge to cut and polish a single silicon carbide wafer from the bulk silicon carbide crystal with a resolution of one atomic layer. The atomic steps are present even in wafers that are referred to as on-axis. In reality the on-axis silicon carbide wafers are slightly off-axis and exhibit the specific pattern of atomic steps which in the growth-preceding process of surface etching will evolve into the characteristic pattern of terraces and step edges.

Graphene's electrical properties differ within the terrace area and in the vicinity of the step edges. As a result, the presence of the macro steps of silicon carbide gives rise to an anisotropy in graphene's sheet resistance. The details of the step-edge-induced anisotropy in graphene's electrical properties were described in [1]. Since the presence of silicon carbide terraces and step edges in unavoidable, so is the anisotropy in graphene's electrical properties.
[1] Ciuk, Tymoteusz; Cakmakyapan, Semih; Ozbay, Ekmel; Caban, Piotr; Grodecki, Kacper; Krajewska, Aleksandra; Pasternak, Iwona; Szmidt, Jan; Strupinski, Wlodek, "Step-edge-induced resistance anisotropy in QFS-bilayer graphene on SiC". Journal of Applied Physics 116, 123708 (2014).

The anisotropy in the electrical properties of epitaxial graphene on silicon carbide is a disadvantage to the applicability of this material in the technology of Hall effect elements as it may significantly increase the offset voltage of the Hall effect element. By definition the offset voltage occurs between the output electrodes when the Hall effect element is sourced with electric current but no magnetic field is yet applied. When the element is sourced with electric current and the magnetic field is applied, a Hall voltage appears between the output electrodes. The offset voltage adds to the Hall voltage and constitutes an operating point of the Hall effect element. In general, the offset voltage has its origin in the finite resolution of the geometry of the active area of the element and in the anisotropy in the electrical properties of the active area. When the active area of the Hall effect element is made of epitaxial graphene on silicon carbide (4H and 6H), the step-edge-induced resistance anisotropy of this material may significantly increase the offset voltage, up to a level that excludes epitaxial graphene on silicon carbide from the application in Hall effect elements.

The offset voltage of a Hall effect element made of epitaxial graphene on silicon carbide (4H and 6H) may be significantly reduced by orienting the element in a precise alignment with respect to the pattern of silicon carbide terraces and step edges. It has been proven that there are two possible and mutually equivalent ways to align the active area of the Hall effect element made of epitaxial graphene on silicon carbide to minimize the offset voltage of the element. Every other alignment will result in the offset voltage being higher than the minimum value.

The essence of the invention is a method for intentional alignment of the Hall effect element, in which the active area is made of epitaxial graphene on silicon carbide, with respect to the pattern of silicon carbide terraces and step edges in order to minimize the offset voltage of the element.

According to the invention a Hall effect element comprising:
a layer of graphene deposited on a layer of silicon carbide; wherein said layer of graphene having a pattern of terraces and step edges arranged in parallel to one another on the surface of said layer of graphene;
at least four metallic elements situated on said layer of graphene and forming ohmic contact with said layer of graphene, wherein
   two of said metallic elements placed at a certain distance opposite to each other are inputs (IN1, IN2) suitable for feeding the Hall effect element with direct current two other of said metallic elements placed at a certain distance opposite to each other are outputs (OUT1, OUT2)
is characterised in that a straight line connecting said inputs (IN1, IN2) forms an angle α equal to 0° or 90° with said terraces and step edges.

Preferably, said inputs (IN1, IN2) and said outputs (OUT1, OUT2) are arranged on the layer of graphene such that a straight line connecting said inputs (IN1, IN2) and a straight line connecting said a said outputs (OUT1, OUT2) intersect each other, preferably at the angle of 90°.

Preferably, a distance between said inputs (IN1, IN2) measuring along with the straight line connecting said inputs (IN1, IN2) is equal to distance between outputs (OUT1, OUT2) measuring along with the straight line connecting said outputs (OUT1, OUT2).

Preferably, said silicon carbide has hexagonal polytypes 4H or 6H.

Preferably, said graphene is an epitaxial graphene.

Preferably, said graphene is pristine or it is intentionally doped.

Preferably, said metallic elements are made of chromium and gold.

Preferably, said layer of silicon carbide is a substrate of silicon carbide and said layer of graphene is deposited directly on said silicon carbide substrate.

### Brief Description of the Drawings

Preferred embodiment of the present invention are presented in a more detailed way with reference to the attached drawing, in which:

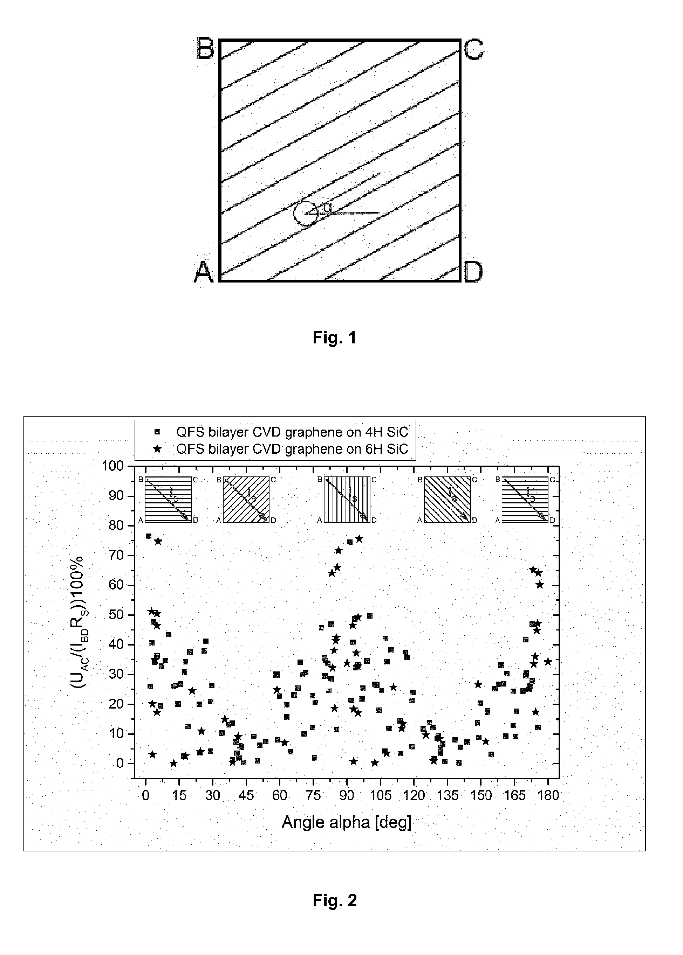

Fig. 1 presents a schematic view of a silicon carbide substrate (10mm×10mm) and the adopted convention for the arbitrary assignment of the angle α of the pattern of silicon carbide terraces and step edges orientation with respect to silicon carbide substrates edges.
fig. 2 shows the statistical analysis of the offset voltage measured between corners A and C, being a result of forcing a constant electric current between corners B and D, in the function of the angle α of the orientation of the pattern of silicon carbide terraces and step edges with respect to the silicon carbide substrate edges. The measured values of the offset voltage are normalized with the value of the forced electric current and the sheet resistance of individual samples. Altogether 200 samples of quasi-free-standing bilayer graphene on silicon carbide were examined.

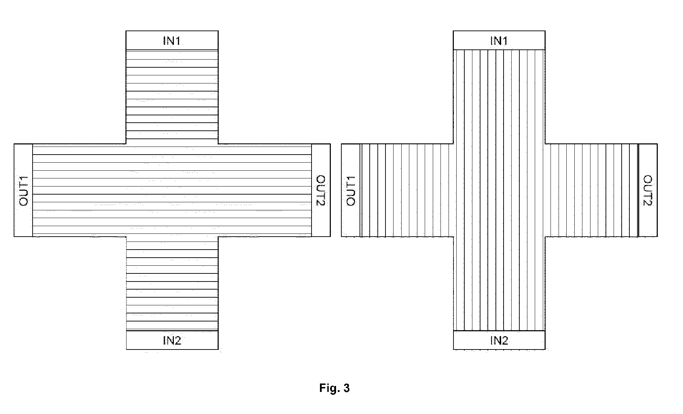

fig. 3 presents two exemplary Hall effect elements in which the active area in the shape of an equal-arm cross is made of epitaxial graphene on silicon carbide. In the first elements the constant electric current forced between IN1 and IN2 flows in the direction perpendicular to the pattern of silicon carbide terraces and step edges, in the second exemplary element the constant electric current forced between metallization pads IN1 and IN2 flows in the direction parallel to the pattern of silicon carbide terraces and step edges.

### Detailed Description

Preferred embodiments of the invention are described in details below. The examples serve only as an illustration and do not limit the scope of the present invention.

The optimum alignment of the Hall effect element made of epitaxial graphene on silicon carbide with respect to the pattern of silicon carbide terraces and step edges is drawn as a conclusion from the following empirical experiment. A set of 200 different samples of quasi-free-standing (hydrogen intercalated) bilayer graphene was synthesized on the Silicon face of the semi-insulating silicon carbide (on-axis) cut to the form of 10mm_{X}10mm substrates. Among these samples 140 were grown on the 4H and 60 on the 6H polytype of silicon carbide. The investigated sample were grown using the vapor phase epitaxy method (EP 2392547 A2).

After growth each sample was characterized in van der Pauw geometry in a Hall effect setup. In this method four point probes are placed in the four corners of a square sample. Prior to the measurement, each graphene sample was inspected under an optical microscope and assigned a specific angle α of the silicon carbide terraces and step edges configuration. The adopted convention for the arbitrary assignment of the value of angle α is presented in Fig.1. The value of the angle α is calculated from the level and spans the range between 0° to 180°, with the terraces and step edges running horizontally (α=0° and α=180°), at an acute angle (α<90°), vertically (α=90°) or at an obtuse angle (90°< α<180°).

During the characterization of each of the samples, four golden probes were placed in the vicinity of the four corners (denoted in Fig.2 by letters A, B, C and D). A constant electric current was forced between probes placed in corners B and D. No magnetic field was applied. A voltage difference between probes placed in corners A and C was analyzed. If the sheet resistance of epitaxial graphene on silicon carbide was isotropic no voltage difference between corners A and C should occur. The experiment proved that an offset voltage measured between corners A and C indeed occurs and its value is a function of the angle α. In the examined set of 200 samples of quasi-free-standing bilayer graphene on silicon carbide the value of the angle α uniformly spanned the entire range of 0° to 180°.

Since every examined sample was grown in a separate process and was characterized by a slightly different sheet resistance the measured offset voltage between corners A and C in every sample were normalized with a factor I_{BD}/R_{S}, where I_{BD} is the value of the constant electric current forced between corners B and D, and R_{S} is the sheet resistance of the individual sample. The resulting values were multiplied by 100%. This approach helped compare samples grown in separate processes.

The statistical analysis of the offset voltage measured between corners A and C, being a result of forcing a constant electric current between corners B and D is presented in Fig.2. The statistics prove that the offset voltage measured between corners A and C is a function of the angle α and that it reaches minimum values for α=45° and α=135°. Based on Fig.1 one may conclude that the minimum value of the offset voltage corresponds to the situation when the constant electric current forced between corners B and D flows either in the direction perpendicular (α=45°) or parallel (α=135°) to the pattern of silicon carbide terraces and step edges. At any other angle α, the offset voltage is higher.

Based on this observation a method for reducing the offset voltage in a Hall effect element made of epitaxial graphene on silicon carbide is suggested. The essence of the method is to consciously align the Hall effect elements made of epitaxial graphene on silicon carbide such a way that the forced electric current flows either perpendicular or in parallel with the pattern of silicon carbide terraces and step edges.

An exemplary Hall effect element in which the active area is made of epitaxial graphene on silicon carbide is presented in Fig.3. The Hall effect element comprises an active area in the form of an equal-arm cross. The length of each of the two cross bars is three times its width. The arms are terminated with metallization pads. Underneath the metallization pads there is also epitaxial graphene and together with the metallization pads it forms an ohmic contact to the active area. Two of the metallization pads serve the function of feeding the Hall effect element with direct current and they are denoted as IN1 and IN2. The other two metallization pads are denoted with OUT1 and OUT2 and it is between these two that the output voltage of the Hall effect element is measured. Within the active area there is schematically shown the pattern of silicon carbide terraces and step edges. The two exemplary elements presented in Fig.3 are aligned with respect to the pattern of silicon carbide terraces and step edges in such a way that the offset voltage measured between OUT1 and OUT2 is minimized. In the first of the exemplary element the constant electric current forced between metallization pads IN1 and IN2 flows in the direction perpendicular to the pattern of silicon carbide terraces and step edges, in the second exemplary element the constant electric current forced between metallization pads IN1 and IN2 flows in the direction parallel to the pattern of silicon carbide terraces and step edges. In both configurations the offset voltage measured between output metallization pads OUT1 and OUT2 is reduced due to the conscious alignment of the Hall effect elements with respect to the pattern of silicon carbide terraces and step edges.

Method for reducing the offset voltage in a Hall effect element made of epitaxial graphene on silicon carbide (hexagonal polytypes 4H and 6H), characterized by the fact that the Hall effect element is aligned with respect to the pattern of silicon carbide terraces and step edges such a way that the forced electric current flows either perpendicular or in parallel with the pattern of silicon carbide terraces and step edges.

## Claims

1. A Hall effect element comprising:
a layer of graphene deposited on a layer of silicon carbide; wherein said layer of graphene having a pattern of terraces and step edges arranged in parallel to one another on the surface of said layer of graphene;
at least four metallic elements situated on said layer of graphene and forming ohmic contact with said layer of graphene, wherein
two of said metallic elements placed at a certain distance opposite to each other are inputs (IN1, IN2) suitable for feeding the Hall effect element with direct current
two other of said metallic elements placed at a certain distance opposite to each other are outputs (OUT1, OUT2)
**characterised in that** a straight line connecting said inputs (IN1, IN2) forms an angle α equal to 0° or 90° with said terraces and step edges.

2. The Hall effect element according to claim 1 **characterized in that** said inputs (IN1, IN2) and said outputs (OUT1, OUT2) are arranged on the layer of graphene such that a straight line connecting said inputs (IN1, IN2) and a straight line connecting said a said outputs (OUT1, OUT2) intersect each other, preferably at the angle of 90°.

3. The Hall effect element according to claim 1 and 2 **characterized in that** a distance between said inputs (IN1, IN2) measuring along with the straight line connecting said inputs (IN1, IN2) is equal to distance between outputs (OUT1, OUT2) measuring along with the straight line connecting said outputs (OUT1, OUT2).

4. The Hall effect element according to claim 1, 2 or 3, **characterized in that** said silicon carbide has hexagonal polytypes 4H or 6H.

5. The Hall effect element according to claims 1-4, **characterized in that** said graphene is an epitaxial graphene.

6. The Hall effect element according to any claims 1-5, **characterized in that** said graphene is pristine or it is intentionally doped.

7. The Hall effect element according to any of claims 1-6, **characterized in that** said metallic elements are made of chromium and gold.

8. The Hall effect element according to any of claims 1-7, **characterized in that** said layer of silicon carbide is a substrate of silicon carbide and said layer of graphene is deposited directly on said silicon carbide substrate.
